# DEMANDE DE BREVET EUROPEEN

(11) **EP 2 685 502 A1**
(43) Date de publication de la demande: **15.01.2014**
(21) Numéro de dépôt: 13175437.6
(22) Date de dépôt: 05.07.2013
(51) Int. Cl.: H01L 27/12, H01L 27/02, H01L 29/786, H01L 27/06

(54) **Circuit integre sur soi comprenant un transistor bipolaire a tranchees d'isolation de profondeurs distinctes**

(30) Priorité: 13.07.2012 FR 1256806
(71) Demandeur: Commissariat à l'Énergie Atomique et aux Énergies Alternatives, 75015 Paris (FR); STmicroelectronics SA, 92120 Montrouge (FR)
(72) Inventeur: Fenouillet-Beranger, Claire, 38000 GRENOBLE (FR); Fonteneau, Pascal, 38570 THEYS (FR)
(74) Mandataire: Guérin, Jean-Philippe

(57) **Abrégé**

L'invention concerne un circuit intégré, comprenant :
-un substrat semi-conducteur (91) ;
-une couche de silicium (15) dans laquelle des composants électroniques (1) sont ménagés ;
-une couche isolante enterrée (92);
-un transistor bipolaire comportant un collecteur (31) et un émetteur (32), un contact de base (33) et une base (35) coplanaires ;
-un caisson (34), disposé à l'aplomb du collecteur, de l'émetteur, de la base et du contact de base, le caisson séparant le collecteur, l'émetteur et le contact de base par rapport au substrat;
-une première tranchée d'isolation (42) disposée à l'aplomb de la base (35) et s'étendant en profondeur au-delà de la couche isolante enterrée (92) sans atteindre le fond du collecteur (34);
-une deuxième tranchée d'isolation (43) séparant le contact de base du collecteur et de l'émetteur, la deuxième tranchée d'isolation s'étendant en profondeur au-delà de la première couche isolante enterrée.

## Description

L'invention concerne les circuits intégrés, et en particulier les circuits intégrés réalisés sur un substrat de type silicium sur isolant (SOI). La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique pour des performances équivalentes. De tels circuits induisent également des capacités parasites plus faibles, qui permettent d'améliorer la vitesse de commutation. De plus, le phénomène de déclenchement parasite (« latchup » en langue anglaise) rencontré par les transistors MOS en technologie Bulk peut être évité. De tels circuits s'avèrent donc particulièrement adaptés pour des applications de type SoC ou MEMS. On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM ou des portes logiques.

La réduction de la consommation statique de portes logiques tout en augmentant leur vitesse de basculement fait l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on rabaisse la tension de seuil de certains transistors des portes logiques à accès rapide, et on augmente la tension seuil d'autres transistors des portes logiques à faible consommation. En technologie Bulk, la modulation du niveau de tension de seuil de transistors de même type est effectuée en différenciant le niveau de dopage de leur canal. Cependant, en technologie FDSOI (pour « Fully Depleted Silicium On Insulator » en langue anglaise, désignant du silicium totalement déserté sur isolant), le dopage du canal est quasiment nul (10¹⁵ cm⁻³). Ainsi, le niveau de dopage du canal des transistors ne peut donc pas présenter de variations importantes, ce qui empêche de différencier les tensions de seuil par ce biais. Une solution proposée dans certaines études pour réaliser des transistors de même type à tensions de seuil distinctes est d'intégrer différents matériaux de grille pour ces transistors. Cependant, la réalisation pratique d'un tel circuit intégré s'avère techniquement délicate et économiquement prohibitive.

Afin de disposer de tensions de seuil distinctes pour différents transistors en technologie FDSOI, il est également connu d'utiliser un plan de masse polarisé disposé entre une couche d'oxyde isolante mince et le substrat de silicium. En jouant sur le dopage des plans de masse et sur leur polarisation, on peut définir une gamme de tensions de seuil pour les différents transistors. On pourra ainsi disposer de transistors à faible tension de seuil dits LVT, de transistors à haute tension de seuil dits HVT et de transistors à tension de seuil moyenne dits SVT.

Pour permettre le fonctionnement des différents transistors, il est nécessaire de les isoler électriquement les uns des autres. Par conséquent, les transistors sont généralement entourés par des tranchées d'isolation (désignées par l'acronyme STI pour « Shallow Trench Isolation » en langue anglaise) qui s'étendent jusqu'aux caissons.

De façon connue, de tels circuits intégrés incluent également des dispositifs de protection contre des décharges électrostatiques (ESD, pour « Electrostatic Discharge » en langue anglaise) accidentelles et pouvant détériorer ces transistors.

II existe un besoin pour une protection contre les décharges électrostatiques ne nuisant pas à la compacité du circuit intégré, capable d'évacuer une décharge localisée quelle que soit sa polarité, et peu coûteux. L'invention porte ainsi sur un circuit intégré tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue de dessus schématique d'une portion de circuit intégré au niveau de plans de masse d'un transistor bipolaire selon une première variante ;
- la figure 2 est une vue en coupe transversale du transistor bipolaire illustré la figure 1 ;
- la figure 3 est une vue en coupe transversale d'un transistor bipolaire selon une deuxième variante ;
- la figure 4 est une vue en coupe transversale d'un transistor bipolaire selon une troisième variante ;
- la figure 5 est une vue en coupe transversale d'un transistor bipolaire selon une quatrième variante ;
- la figure 6 est une vue en coupe transversale d'un transistor bipolaire selon une cinquième variante ;
- la figure 7 est une vue en coupe transversale d'un transistor bipolaire selon une sixième variante ;
- la figure 8 est une vue en coupe transversale d'un exemple de transistor bipolaire accolé à un transistor à effet de champ ;
- la figure 9 est une vue en coupe transversale d'un autre exemple de transistor bipolaire accolé à un transistor effet de champ.

L'invention propose d'utiliser, dans un circuit intégré de type SOI, des tranchées d'isolation de profondeurs et de dimensions différentes afin de réaliser des transistors bipolaires.

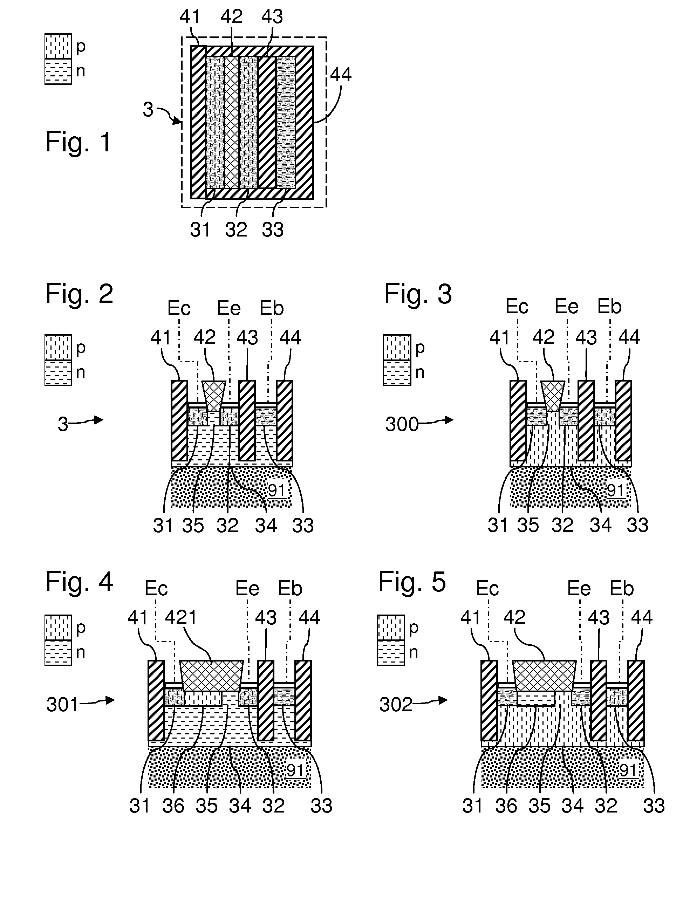

La figure 1 est une vue de dessus schématique d'une portion d'un circuit intégré de type SOI. Le circuit intégré comporte ici un transistor bipolaire 3. Le transistor bipolaire 3 est illustré en coupe transversale à la figure 2. Le circuit intégré comporte d'autres composants électroniques ménagés sur une couche d'isolant enterrée, non illustrée ici.

Le transistor 3 est formé à l'aplomb d'un substrat semi-conducteur 91. Ce substrat 91 a un dopage de type p. Le transistor 3 est ici de type pnp. Le transistor 3 comporte un collecteur 31, un émetteur 32 et un contact de base 33. Le collecteur 31 inclut un élément semi-conducteur à dopage de type p, l'émetteur 32 comprend un élément semi-conducteur à dopage de type p, et le contact de base 33 comprend un élément semi-conducteur à dopage de type n. Un élément semi-conducteur à dopage de type n forme :
- d'une part un caisson 34 à l'aplomb du collecteur 31, de l'émetteur 32 et du contact de base 33 ;
- d'autre part une base 35 formant une jonction entre le collecteur 31 et l'émetteur 32.

Le collecteur 31, l'émetteur 32 et le contact de base 33 incluent ici des zones implantées ménagées au-dessus du caisson 34. Les zones implantées présentent avantageusement des dopages respectifs P+, P+ et N+. La base 35 et les zones implantées du collecteur 31, de l'émetteur 32 et du contact de base 33 sont ici coplanaires. Par coplanaire, on entend que l'on peut définir un plan traversant les zones concernées et parallèle à la couche isolante enterrée détaillée par la suite. Le collecteur 31, l'émetteur 32 et le contact de base 33 sont connectés respectivement à des potentiels Ec, Ee et Eb. On forme ainsi un transistor bipolaire 3 dans lequel le contact de base est déporté latéralement par rapport au collecteur et à l'émetteur.

Le transistor 3 comporte à sa périphérie une tranchée d'isolation 44 s'étendant en profondeur jusqu'au caisson 34. Le transistor 3 comporte ici également à sa périphérie une tranchée d'isolation 41 s'étendant en profondeur jusqu'au caisson 34. Le transistor 3 comporte en outre une tranchée d'isolation 43 s'étendant en profondeur jusqu'au caisson 34. La tranchée d'isolation 43 sépare ou est interposée entre l'émetteur 32 et le contact de base 33. La tranchée d'isolation 43 ne s'étend pas jusqu'au substrat 91. Ainsi, le caisson 34 forme un élément semi-conducteur continu entre le contact de base 33 et la base 35. La base 35 est par exemple formée dans la continuité de l'élément semi-conducteur dans lequel le caisson 34 est formé. Les tranchées d'isolation 41 et 44 ne s'étendent pas jusqu'au substrat 91.

Le transistor 3 comporte en outre une tranchée d'isolation 42 ménagée à l'aplomb de la base 35. La tranchée 42 présente de préférence une largeur d'au moins 40 nm pour un noeud technologique de 20 nm. La tranchée d'isolation 42 s'étend jusque dans la base 35, jusqu'en dessous de la face supérieure du collecteur 31 et de l'émetteur 32. La tranchée d'isolation 42 s'étend par exemple entre 5 et 50 nm en dessous de la surface supérieure du collecteur 31 ou de l'émetteur 32. La tranchée d'isolation 42 peut également s'étendre entre 5 et 50 nm en dessous de la couche d'isolant enterrée du circuit intégré pour un transistor 3 de type FDSOI. Le fond de la couche isolante enterrée est ici au niveau de la surface supérieure du collecteur 31, de l'émetteur 32 et du contact de base 33. La tranchée d'isolation 42 ne s'étend cependant pas jusqu'à l'interface entre le caisson 34 et le collecteur 31 ou l'émetteur 32. La tranchée d'isolation 42 est moins profonde que les tranchées d'isolation 43 et 44.

Ainsi on obtient un transistor bipolaire 3 pour lequel les propriétés de la base 35 sont particulièrement bien contrôlées durant le processus de fabrication. Par ailleurs, pour une utilisation du transistor 3 dans une protection du circuit intégré contre les décharges électrostatiques, un tel transistor limite fortement l'apparition d'une surintensité par le phénomène de courant de retournement (snapback en langue anglaise). L'utilisation d'une tranchée d'isolation 43 plus profonde que la tranchée d'isolation 42 permet d'accroître la sensibilité du déclenchement de la protection pour limiter la surintensité induite dans le transistor 3 lorsqu'il est traversé par une décharge électrostatique.

Le caisson 34 peut présenter une concentration de dopants comprise entre 10¹⁶cm⁻³ et 10¹⁸cm⁻³ . Le caisson 34 peut s'étendre jusqu'à une profondeur inférieure à 1µm et, de préférence, inférieure ou égale à 700nm.

Avantageusement, les zones implantées du collecteur 31, de l'émetteur 32 et du contact de base 33 présentent chacun une concentration de dopants au moins cinquante fois, ou cent fois supérieure à la concentration de dopants du caisson 34. Par exemple, ces zones implantées présentent des concentrations de dopants avantageusement supérieures ou égales à 5*10¹⁸cm⁻³ et, de préférence, comprises entre 10¹⁹cm⁻³ et 10²¹cm⁻³.

La figure 3 est une vue en coupe transversale d'une variante de transistor bipolaire 300 du circuit intégré. Le transistor 300 est ici de type npn. Le transistor 300 présente une structure identique à celui de la figure 2 et se différencie de celui-ci par les types de dopage utilisés. Ainsi, le collecteur 31 inclut un élément semi-conducteur à dopage de type n, l'émetteur 32 comprend un élément semi-conducteur à dopage de type n, et le contact de base 33 comprend un élément semi-conducteur à dopage de type p. Un élément semi-conducteur à dopage de type p forme :
- d'une part le caisson 34 à l'aplomb du collecteur 31, de l'émetteur 32 et du le contact de base 33 ;
- d'autre part la base 35 entre le collecteur 31 et l'émetteur 32.

La base 35 et les zones implantées du collecteur 31, de l'émetteur 32 et du contact de base 33 sont ici coplanaires.

La figure 4 est une vue en coupe transversale d'une autre variante de transistor bipolaire 301 du circuit intégré. Le transistor 301 est ici de type pnp. Le transistor 301 présente des tranchées 41, 43 et 44 similaires à celles du transistor de la figure 2. Le collecteur 31, l'émetteur 32, le contact de base 33 et le caisson 34 du transistor 301 de la figure 4 présentent une structure et un dopage identiques à ceux du transistor de la figure 3. La tranchée d'isolation 42 présente ici une largeur supérieure à la largeur de la tranchée 42 du transistor de la figure 2. La tranchée d'isolation 421 présente la même profondeur que la tranchée 42 du transistor de la figure 2. La tranchée 421 est ici ménagée à l'aplomb d'un élément semi-conducteur 36 et de la base 35. L'élément semi-conducteur 36 est interposé en contact avec le collecteur 31 et la base 35. L'élément semi-conducteur 36 forme un prolongement du collecteur 31 sous la tranchée d'isolation 421. La tranchée 421 présente de préférence une largeur d'au moins 80 nm pour un noeud technologique de 20 nm. L'élément semi-conducteur 36 comporte un dopage de type p et est en contact avec le collecteur 31. L'élément semi-conducteur 36 comporte avantageusement une largeur au moins égale à 40 nm pour un noeud technologique de 20 nm.

L'élément semi-conducteur 36, la base 35 et les zones implantées du collecteur 31, de l'émetteur 32 et du le contact de base 33 sont ici coplanaires. L'ajout de l'élément semiconducteur 36 permet d'accroître la tension de claquage base/émetteur du transistor 301.

La figure 5 est une vue en coupe transversale d'une variante de transistor bipolaire 302 du circuit intégré. Le transistor 302 est ici de type npn. Le transistor 302 présente une structure identique à celui de la figure 4 et se différencie de celui-ci par les types de dopage utilisés. Ainsi, le collecteur 31 inclut un élément semi-conducteur à dopage de type n, l'émetteur 32 comprend un élément semi-conducteur à dopage de type n, et le contact de base 33 comprend un élément semi-conducteur à dopage de type p. L'élément semi-conducteur 36 comporte un dopage de type n. Un élément semi-conducteur à dopage de type p forme :
- d'une part le caisson 34 à l'aplomb du collecteur 31, de l'émetteur 32 et du contact de base 33 ;
- d'autre part la base 35 entre l'élément semi-conducteur 36 et l'émetteur 32.

L'élément semi-conducteur 36, la base 35 et les zones implantées du collecteur 31, de l'émetteur 32 et du contact de base 33 sont ici coplanaires.

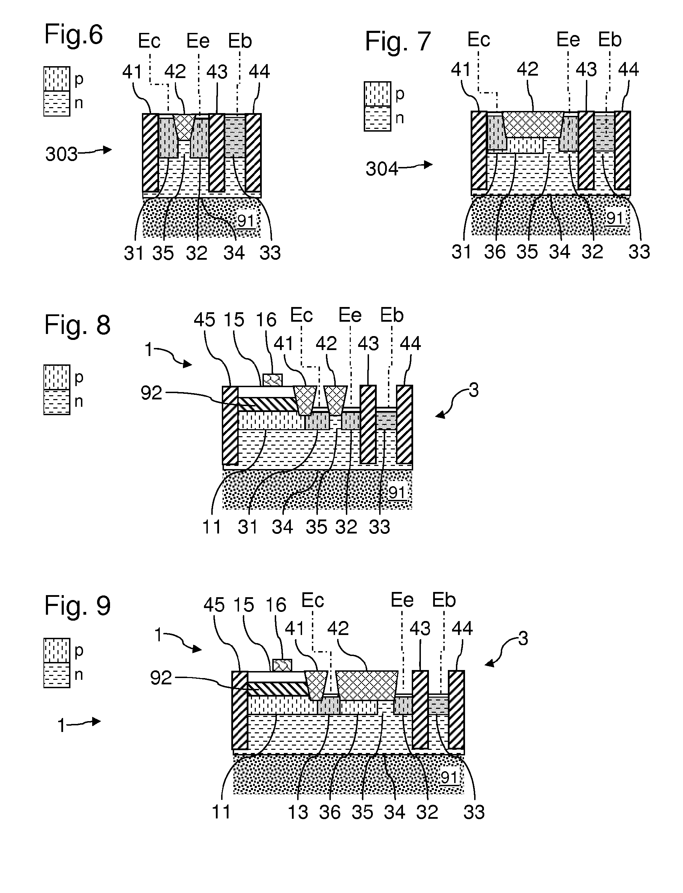

La figure 6 est une vue en coupe transversale d'une autre variante d'un transistor bipolaire 303 du circuit intégré. Le transistor 303 est identique à celui de la figure 2 à l'exception de la structure du collecteur 31, de l'émetteur 32, et du contact de base 33. Dans cet exemple, au moyen d'une reprise d'épitaxie, on a réalisé un collecteur 31, un émetteur 32, et un contact de base 33 affleurant à la surface supérieure des tranchées d'isolation 41 à 44. Par conséquent, la surface supérieure du collecteur 31, de l'émetteur 32, et du contact de base 33 est disposée au-dessus du fond de la couche isolante enterrée pour un transistor 303 de type FDSOI.

La figure 7 est une vue en coupe transversale d'une autre variante d'un transistor bipolaire 304 du circuit intégré. Le transistor 304 est identique à celui de la figure 4 à l'exception de la structure du collecteur 31, de l'émetteur 32, et du contact de base 33. Dans cet exemple, au moyen d'une reprise d'épitaxie, on a réalisé un collecteur 31, un émetteur 32, et un contact de base 33 affleurant à la surface supérieure des tranchées d'isolation 41 à 44. Par conséquent, la surface supérieure du collecteur 31, de l'émetteur 32, et du contact de base 33 est disposée au-dessus du fond de la couche isolante enterrée pour un transistor 304 de type FDSOI.

Dans l'exemple de la figure 8, le transistor bipolaire 3 est accolé à un transistor à effet de champ 1. Le transistor 1 est par exemple un transistor nMOS ou pMOS. Le transistor 1 comporte de façon connue en soi une source, un drain et un canal, et un empilement de grille réalisé à l'aplomb du canal. La source, le drain et le canal du transistor 1 sont ménagés dans la couche active semi-conductrice 15. Le transistor 1 comporte un empilement de grille 16 disposé sur la couche active semi-conductrice 15, à l'aplomb du canal. Pour simplifier les dessins, la structure détaillée des couches actives n'y est pas représentée. Le transistor 1 peut être de type FDSOI et comporter de façon connue en soi un canal en matériau semi-conducteur faiblement dopé, avec une concentration de dopants sensiblement égale à la concentration de dopants du substrat 91. Le transistor 1 comporte également des électrodes de source et de drain, non illustrées.

Le transistor 1 est ménagé à l'aplomb d'une couche isolante enterrée 92. La couche isolante enterrée 92, de façon connue en soi, isole électriquement le transistor 1 de son plan de masse 11, de son caisson 34, et du substrat 91.

Un plan de masse 11 semi-conducteur est formé à l'aplomb du transistor 1, sous la couche isolante enterrée 92. Le dopage du plan de masse 11 est ici du même type que le dopage du collecteur 31, c'est-à-dire de type p. La zone implantée du collecteur 31 est en contact avec le plan de masse 11. Le plan de masse 11 est donc polarisé au potentiel Ec. La polarisation du plan de masse 11 peut être effectuée par l'intermédiaire d'un circuit de commande non représenté ici. Le caisson 34 s'étend latéralement jusqu'à l'aplomb du plan de masse 11.

La couche isolante enterrée 92 formée à l'aplomb du transistor 1 est ici de type UTBOX (« Ultra-Thin Buried Oxide Layer » en langue anglaise). Ainsi, le contrôle de la polarisation du plan de masse 11 permet de moduler la tension de seuil du transistor 1. La couche isolante 92 présente par exemple une épaisseur inférieure ou égale à 60nm, inférieure ou égale à 50nm, voir inférieure ou égale à 20nm. La couche isolante 92 peut être réalisée de façon connue en soi en oxyde de silicium.

Une tranchée d'isolation 45 est ménagée à la périphérie du transistor 1. La tranchée d'isolation 45 s'étend à travers la couche isolante enterrée 92, jusqu'au caisson 34. La tranchée d'isolation 45 présente avantageusement une profondeur identique aux tranchées d'isolation 43 et 44.

La tranchée d'isolation 41 est ici ménagée à l'aplomb du contact entre le plan de masse 11 et la zone implantée du collecteur 31. La tranchée d'isolation 41 s'étend à travers la couche isolante enterrée 92. La tranchée d'isolation 41 ne s'étend pas jusqu'au caisson 34 ou jusqu'au fond du collecteur 31, afin de permettre un contact entre le collecteur 31 et le plan de masse 11. La tranchée d'isolation 41 présente avantageusement la même profondeur que la tranchée d'isolation 42.

Le plan de masse 11 peut présenter une concentration de dopants comprise entre 10¹⁸cm⁻³ et 10¹⁹cm⁻³. Les concentrations de dopants des zones implantées du collecteur 31, de l'émetteur 32 et du contact de base 33 sont par exemple sensiblement égales aux concentrations de dopants de la source ou du drain du transistor 1. Des contacts métalliques peuvent être déposés après siliciuration directement sur chacune des zones implantées du collecteur 31, de l'émetteur 32 et du contact de base 33, afin de permettre une connexion électrique de chacun d'eux.

Le transistor bipolaire 3 peut être utilisé en combinaison avec le transistor à effet de champ 1. Le transistor 3 peut par exemple être utilisé pour protéger le transistor 1 contre des décharges électrostatiques, ou être commandé par le transistor 1 pour se fermer en présence d'une décharge électrostatique. La combinaison des transistors 1 et 3 n'implique qu'une diminution réduite de la densité d'intégration :
- le collecteur 31 du transistor bipolaire 3 sert également à polariser le plan de masse 11 ;
- l'émetteur 32 du transistor bipolaire 3 sert également à polariser le caisson 34 à l'aplomb du transistor 1.

La figure 9 illustre un autre exemple de transistor bipolaire 3 accolé à un transistor à effet de champ 1. Cet exemple diffère de celui de la figure 8 uniquement par l'utilisation d'un transistor bipolaire 3 tel que défini en référence à la figure 4. Dans cet exemple, le transistor 3 assure avantageusement une protection accrue du transistor 1 contre les décharges électrostatiques du fait d'une tension de claquage base/collecteur plus élevée. Le seuil de déclenchement du transistor 3 est ici relevé, ce qui est utile en particulier pour une utilisation avec des niveaux de tension élevés.

Bien entendu, les transistors bipolaires des figures 6 et 7 peuvent être accolés à un transistor à effet de champ.

## Revendications

1. Circuit intégré, **caractérisé en ce qu'il** comprend :
- un substrat semi-conducteur (91) ;
- une couche de silicium (15) dans laquelle des composants électroniques (1) sont ménagés ;
- une couche isolante enterrée (92) disposée entre le substrat semi-conducteur (91) et la couche de silicium (15) ;
- un transistor bipolaire comportant un collecteur (31) et un émetteur (32) présentant un premier type de dopage, une base (35) et un contact de base (33) présentant un deuxième type de dopage différent du premier, la base formant une jonction avec le collecteur et avec l'émetteur, le collecteur, l'émetteur, ledit contact de base et la base étant coplanaires ;
- un caisson (34) présentant le deuxième type de dopage, disposé à l'aplomb du collecteur, de l'émetteur, du contact de base et de la base, le caisson séparant le collecteur, l'émetteur et le contact de base par rapport au substrat, le caisson présentant le deuxième type de dopage et s'étendant entre le contact de base et la base ;
- une première tranchée d'isolation (42) disposée à l'aplomb de la base (35) et s'étendant en profondeur au-delà de la couche isolante enterrée (92) sans atteindre le fond de l'émetteur et du collecteur (34);
- une deuxième tranchée d'isolation (43) disposée entre le contact de base d'une part et le collecteur et l'émetteur d'autre part, la deuxième tranchée d'isolation s'étendant en profondeur au-delà de la couche isolante enterrée jusque dans le caisson jusqu'à une profondeur supérieure à la profondeur de la première tranchée d'isolation.

2. Circuit intégré selon la revendication 1, dans lequel la première tranchée d'isolation (42) s'étend en profondeur entre 5 et 50 nm au-delà de la couche isolante enterrée (92).

3. Circuit intégré selon la revendication 1 ou 2, dans lequel le collecteur (31), l'émetteur (32) et le contact de base (33) incluent chacun une zone implantée semi-conductrice présentant une concentration de dopants au moins cinquante fois supérieure à la concentration de dopants du caisson (34).

4. Circuit intégré selon la revendication 3, dans lequel le collecteur (31) comporte un élément semi-conducteur (36) en contact avec sa zone implantée et avec la base, l'élément semi-conducteur présentant le premier type de dopage, la base (35) étant en contact avec la zone implantée de l'émetteur (32).

5. Circuit intégré selon la revendication 4, dans lequel la première tranchée d'isolation (42) présente une largeur au moins égale à 80 nm.

6. Circuit intégré selon la revendication 3 ou 4, dans lequel la zone implantée du collecteur (31) présente un dopage au moins 50 fois supérieur au dopage de l'élément semi-conducteur (36).

7. Circuit intégré selon la revendication 3, dans lequel la base (35) est en contact avec la zone implantée du collecteur (31) et avec la zone implantée de l'émetteur (32).

8. Circuit intégré selon l'une quelconque des revendications 3 à 7, dans lequel la face supérieure desdites zones implantées est affleurante à la partie supérieure de la première tranchée d'isolation (42).

9. Circuit intégré selon l'une quelconque des revendications précédentes, comprenant :
- un transistor à effet de champ (1) ménagé à l'aplomb de la couche isolante enterrée ;
- un plan de masse (11) ménagé à l'aplomb du transistor à effet de champ, le plan de masse étant en contact avec une électrode parmi le collecteur (31) ou l'émetteur (32), et présentant le premier type de dopage ;
- une troisième tranchée d'isolation (41) disposée à l'aplomb du contact entre le plan de masse et ladite électrode, et s'étendant à travers la couche isolante enterrée sans atteindre le caisson (34).

10. Circuit intégré selon la revendication 9, dans lequel le collecteur et l'émetteur sont disposés entre le contact de base et le transistor à effet de champ.

11. Circuit intégré selon la revendication 9 ou 10, dans lequel le transistor à effet de champ (1) est de type FDSOI.

12. Circuit intégré selon l'une quelconque des revendications 9 à 11, dans lequel le caisson (34) s'étend à l'aplomb dudit plan de masse (11).
